Europäisches Patentamt

European Patent Office

Office européen des brevets

(19)

(11) Publication number: **0 383 097 A2**

## (12) EUROPEAN PATENT APPLICATION

(21) Application number: **90101908.3**

(51) Int. Cl.5: **G06F 12/08**

(22) Date of filing: **31.01.90**

(30) Priority: **14.02.89 JP 34845/89**

(43) Date of publication of application:
**22.08.90 Bulletin 90/34**

(84) Designated Contracting States:
**DE FR GB IT**

(71) Applicant: **HITACHI, LTD.**
**6, Kanda Surugadai 4-chome**
**Chiyoda-ku, Tokyo 100(JP)**

Applicant: **HITACHI VLSI ENGINEERING**
**CORPORATION**
**20-1, Jousuihoncho 5-chome**
**Kodaira-shi Tokyo(JP)**

(72) Inventor: **Saigou, Yasuhiko**
**Nishikokubunjiryo 2-6, Kitayama-cho**
**Fuchuu-shi, Tokyo(JP)**
Inventor: **Fukuta, Hiroshi**
**1-10-4 Ogawahigashi-cho**
**Kodaira-shi, Tokyo(JP)**
Inventor: **Kikuchi, Takashi**
**Haijimaryo 5-5-7, Mihori-cho**
**Akishima-shi, Tokyo(JP)**
Inventor: **Konoma, Toshihiko**
**Haijimaryo 5-5-7, Mihori-cho**
**Akishima-shi, Tokyo(JP)**

Inventor: **Nagashima, Osamu**
**101, Koopoishii 2-6-3, Kawasaki,**
**Hamura-machi**
**Nishitama-gun, Tokyo(JP)**
Inventor: **Uchiyama, Kunio**
**A-301, 2-32 Koyasu-cho**
**Hachioji-shi, Tokyo(JP)**
Inventor: **Aoki, Hirokazu**
**Hitachi-oowadaryo, 1-48-18, Akatsuki-cho**
**Hachioji-shi, Tokyo(JP)**
Inventor: **Nishii, Osamu**
**Hitachi-dai4-kyoshinryo, 4-14-6,**
**Nishikoigakubo**
**Kokubunji-shi, Tokyo(JP)**
Inventor: **Oishi, Kanji**
**5-16-38, Midori-cho**
**Koganei-shi, Tokyo(JP)**
Inventor: **Kitano, Jun**
**4-35-14, Nakaarai**
**Tokorozawa-shi, Saitama(JP)**
Inventor: **Hatano, Susumu**
**Hitachi-seiwaryo, 1-20-12 Sakai**
**Musashino-shi, Tokyo(JP)**

(74) Representative: **Strehl, Schübel-Hopf,**
**Groening**
**Maximilianstrasse 54 Postfach 22 14 55**
**D-8000 München 22(DE)**

(54) **Cache memory.**

(57) A cache memory is connected to the microprocessor via a MPU bus and to the main memory via a memory bus. The data transfer between the main memory and the data memory DTM of the cache memory is executed block by block via the buffer memory BM. The directory memory DLM holds, as address tags, the high-order bits of the main memory addresses of the data stored in the data memory DTM. A tag comparator TCP compares an address tag stored in the directory memory DLM with the address tag derived from the MPU-bus and produces a signal CH which indicates a coindicende (cache-hit) or a non-coincidence (mis-hit). In the case of a cache-hit, a data transfer is executed between the microprocessor and the data memory DTM instead of the main memory.

The cache memory has a function of monitoring any address change in the main memory due to a dynamic relocation or garbage collection e.g. The address change implies a data-transfer start address and a data-transfer end address.

In case of an address change in the main memory, the cache memory automatically updates the internal address tag in conformity with the data-

transfer start and end address.

FIG. 1

## Cache Memory

[Industrial Field of Utilization]

The present invention relates to a storage control technique and, more particularly, to a technique effectively utilizable for a cache memory employed in a data processing system of buffer storage type.

[Prior Art]

There is known a buffer storage type microcomputer system where some data used frequently are stored in a cache memory out of the entire data contents in a main memory comprising a dynamic RAM (random access memory) and so forth, and such data are controlled by means of a memory control unit generally termed a cache controller, so as to enhance the throughput of the system.

The cache memory is accessed by an address outputted from a microprocessor, and if desired data is existent in the cache memory or a cache hit occurs, the microprocessor can obtain the data immediately from the fast cache memory instead of the main memory. In the cache controller, the internal address (tag) is compared with the address outputted from the microprocessor and, if the result of such comparison signifies that the desired data is not existent in the cache memory, a signal indicating a mis-hit is outputted. Then the microprocessor accesses the main memory to obtain the desired data therefrom.

Regarding such cache memory, there is a known disclosure in, for example, Nikkei McGraw-Hill Co., "Nikkei Electronics", Nov. 16, 1987, p.170.

[Problems to be Solved by the Invention]

In the microcomputer system or the like, a process of dynamic relocation is executed to widen the usable memory space by eliminating any vacant address between a series of data groups in physical addresses. Execution of such dynamic relocation causes changes of the addresses in the main memory, so that the exact correspondence or conformity to the addresses in the cache memory fails to be maintained. For this reason, the data in the cache memory are rendered invalid by removing the valid bit regardless of the existence of effective data.

Consequently, after execution of such dynamic relocation, a mis-hit is induced despite the existence of the effective data in the cache memory, hence raising a problem that the cache memory is not used efficiently.

It is therefore an object of the present invention to provide an improved cache memory which realizes further enhancement in the throughput of the data processing system.

The above and other objects of the present invention with novel advantages and features thereof will become apparent from the following description in this specification and the accompanying drawings.

[Means for Solving the Problems]

Summarizing a typical one of the inventive features disclosed in this application, the cache memory is equipped with a function of monitoring any address change in a main memory and automatically changing an internal address tag and/or a storage location in conformity with a data-transfer start address.

[Function]

According to the means mentioned, even when a process such as dynamic relocation or garbage collection is performed by the microprocessor to change the data storage address in the main memory, the data in the cache memory is effectively usable due to the function described above, hence enhancing the throughput of the system.

[Preferred Embodiments]

Preferred embodiments of the invention will be described in conjunction with the accompanying drawings in which:

Fig. 1 is a block diagram showing an embodiment of the cache memory according to the present invention;

Fig. 2 is a block diagram of an exemplary microcomputer system where the cache memory of the invention is employed;

Fig. 3 shows a memory map for explaining an exemplary process of dynamic relocation;

Fig. 4 is a conceptional diagram of an exemplary correspondence between the address and the data in the address map of a main memory, and the directory memory part and the data memory part in the cache memory;

Fig. 5 shows operation modes with combinations of content changes or transfers in the directory memory part and the data memory part in the cache memory;

Fig. 6 shows a memory map with exemplary data transfers executed in the main memory due to dynamic relocation or garbage collection;

Fig. 7 shows a memory map with exemplary data changes in the cache memory conforming with Fig. 6;

Fig. 8 is a conceptional diagram showing an exemplary data transfer in the cache memory; and

Fig. 9 is a timing chart relative to the data transfer of Fig. 8.

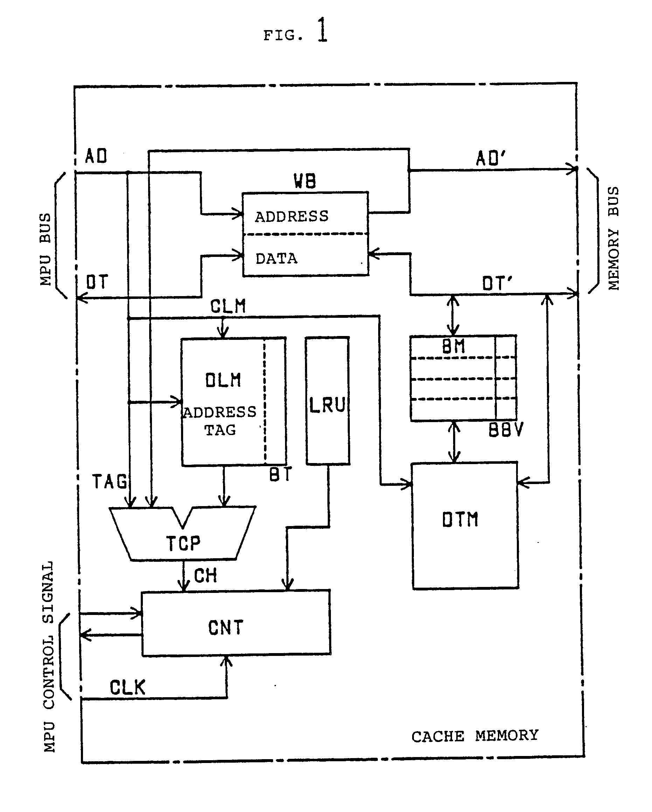

Fig. 1 is a block diagram showing an exemplary embodiment of the cache memory according to the present invention. In this diagram, the cache memory is formed either solely or together with a microprocessor and so forth on a single semiconductor substrate by the known technology for production of a semiconductor integrated circuit.

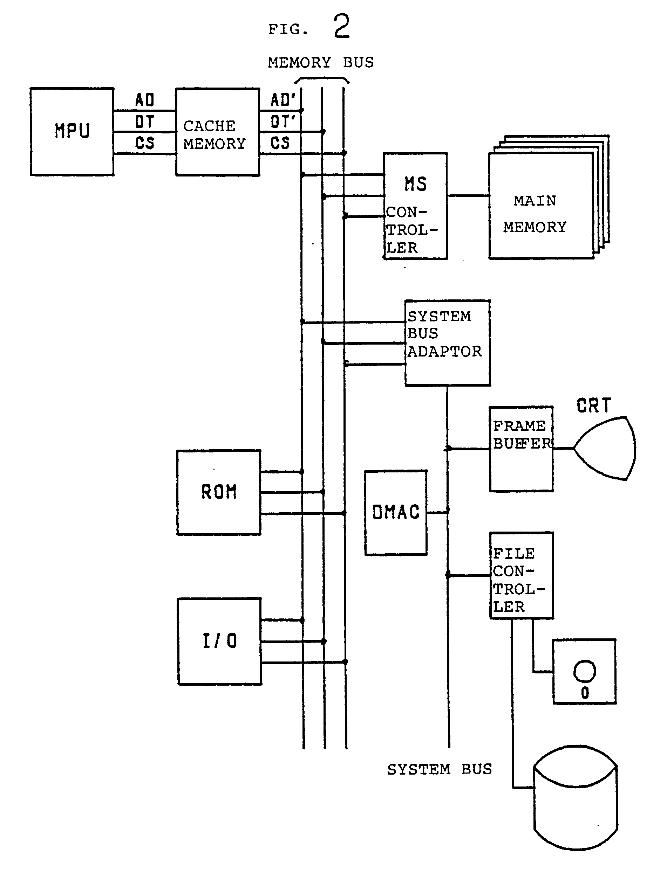

Before giving a detailed description of the cache memory in this embodiment, an exemplary microcomputer system employing such cache memory will be mentioned with reference to a block diagram of Fig. 2.

A microprocessor MPU is connected to one port of the cache memory via an address bus AD, data bus DT and a control bus CS. Meanwhile the other port of the cache memory is connected to a memory bus. That is, a main memory comprising a dynamic RAM and so forth is connected to the memory bus via a main storage (MS) controller circuit. In addition to such main memory, there are also connected a read only memory (ROM), an input/output port I/O and a system bus adaptor to the memory bus in accordance with requirements. And so the system bus adaptor, there are connected some terminal units such as a display CRT and so forth via a frame buffer, and also magnetic memory units such as a floppy memory and a hard disc memory via a file controller. Furthermore, a direct memory access controller DMAC for directly transferring data without passing the same via the microprocessor MPU is disposed between such external memories and the main memory. All of such units are mounted on a system bus provided by the aforementioned system bus adaptor.

In Fig. 1, the cache memory is constituted of a memory section and a control section, although not restrictive particularly. The memory section comprises a directory memory DLM, a data memory DTM, a buffer memory BM and a write buffer WB. Meanwhile the control section comprises an LRU (least recently used) type block replace controller LRU, a tag comparator TCP and a circuit controller CNT for controlling such circuits.

The write buffer WB functions to temporarily hold a write address and write data therein. And in a write mode, the microprocessor MPU and so forth terminate the operation by writing in the write buffer WB as will be described later. The write buffer WB is connected to two internal buses. One internal address bus AD and the data bus DT are connected to the port coupled to the bus from the microprocessor MPU. Meanwhile the other internal address bus AD′ and the data bus DT′ are connected to the port coupled to the bus from the main memory, as will be described later. Due to such circuit connection, the address signal for accessing the main memory is fed via the write buffer to the main memory. The data storage buffer included in the write buffer WB is used also in a read mode, and the data read out from the cache memory or the main memory is once passed through the data buffer and then is transmitted to the MPU bus to which the microprocessor MPU is coupled. That is, the data buffer has another function as a bidirectional bus driver.

The buffer memory BM is used when reading out the data from the cache memory or when transferring the data block-by-block between the main memory and the cache memory. For example, the data transfer between the main memory and the data memory DTM of the cache memory is executed block-by-block via the buffer memory BM. And the reading operation at the time of a cache hit is performed in such a manner that one word out of the data of each block loaded in the buffer memory BM is selectively outputted.

The buffer memory BM consists of a dual-port register having a port to transmit or receive the data to or from the main memory for the aforementioned data transfer, and a port to transmit or receive the data to or from the data memory DTM. There is further formed a signal path through which the data read out from the memory DTM is directly outputted to the internal data bus DT′ toward the main memory.

In the directory memory DLM are stored, as address tags, address signals composed of 10 high-order bits in the main memory addresses of the data stored at the same column positions as those in the data memory DTM. Out of the address signal fed from the microprocessor to the address bus AD of the cache memory, a column address portion CLM is supplied to a common decoder of the directory memory DLM and the data memory DTM. Accordingly, the address tag obtained from the directory memory DLM and the data from the data memory DTM are outputted simultaneously. In this stage, the data of one block is read out as a batch from the data memory DTM and then is transferred to the buffer memory BM.

The address tag read out from the directory memory DLM is supplied to one input of the tag comparator TCP. Meanwhile the address TAG in the tag portion of the address AD fed from the microprocessor MPU is supplied to the other input of the tag comparator TCP. Therefore, the tag comparator TCP immediately performs a comparison in response to the address tag received from the directory memory DLM and produces a signal CH which indicates a coincidence (cache hit) or a non-coincidence (mis-hit).

In the case of a cache hit, the data is read out from the corresponding column position in the data memory DTM and, out of the 1-block data already transferred to the buffer memory BM, the 1-word data designated by the 2 low-order bits of the address signal is selected by an unshown selector and then is transmitted to the microprocessor via the data bus $DT'$, the data buffer and the data bus DT.

In the case of a mis-hit, the address signal is transmitted to the main memory bus via the internal address bus AD, the address buffer of the write buffer WB and the internal address bus $AD'$, so that the main memory is accessed and a data reading operation is performed. Then the data thus read out from the main memory is transmitted to the microprocessor via the main memory data bus, the internal bus $DT'$, the data buffer and the internal bus DT.

Upon occurrence of a mis-hit in a data write mode, the main memory is accessed by the address signal and the write data held in the write buffer WB, whereby a writing operation is performed. In this stage, such address and data are stored also in the cache memory simultaneously with the above writing operation.

Although not restrictive particularly, the directory memory DLM includes a transfer bit BT which signifies whether the data requested bit-by-bit per column by the microprocessor MPU is during block transfer or not from the main memory to the cache memory. There is also included a bit BBV signifying whether the data is valid or invalid correspondingly to each word of the buffer memory BM.

The states of such bits BT and BBV are monitored by the controller CNT to regulate the data transfer control, and such bits are rewritten by the controller CNT in accordance with flow of the data transfer.

Upon detection of a cache hit from the result of comparing the tag of the address fed from the microprocessor MPU, the state of the column-position bit BT is checked and, in the case of a logic "0" indicating that the desired data is existent in the data memory DTM, the data in the data memory DTM is inputted to the data buffer via the internal data bus $DT'$, and simultaneously the cache hit signal is returned to the microprocessor MPU.

Even in the case of a cache hit, the desired data is existent in the buffer memory BM if the transfer bit BT is logic "1". Therefore the bit BBV in the buffer memory BM is checked and, when its value is logic "1", the word data is inputted to the data buffer via the internal data bus $DT'$, and the cache hit signal is returned to the microprocessor MPU. In case the bit BBV is logic "0", there arises a wait until the bit BBV is turned to logic "1" by the data transfer from the main memory. And upon turn of such bit to logic "1", the word data is inputted to the data buffer via the internal data bus $DT'$, and the cache hit signal is returned to the microprocessor MPU.

The controller CNT functions in response to occurrence of a block transfer factor, so that first the corresponding bit BT in the directory memory DLM is set to logic "1" and then the data transfer is started. Thereafter the bit BBV in the buffer memory BM is set to logic "1" in accordance with the data transfer state and, when each bit BBV of the entire word data in the block has become logic "1", the data in the buffer memory BM is transferred to the main memory or the data memory DLM. And upon completion of such transfer, the bit BBV and the bit BT in the directory memory DLM are set to logic "0" respectively.

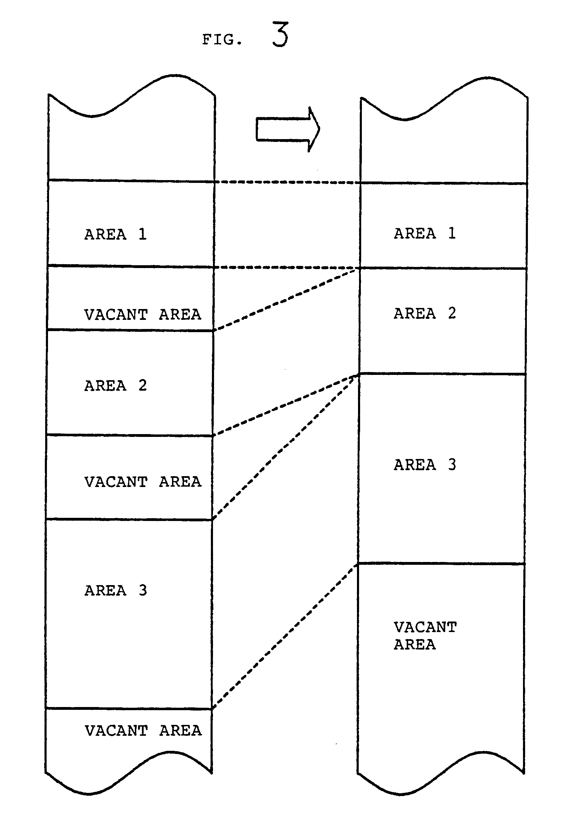

Fig. 3 shows a memory map for explaining the dynamic relocation executed in the main memory.

On the left side of Fig. 3 is illustrated an address map anterior to execution of such dynamic relocation. As shown, there are existent vacant areas among a plurality of areas 1 through 3 where a series of data are stored. Because of such vacant areas, the efficiency of using the memory space in the main memory is deteriorated to consequently bring about reduction of the throughput of the system. Therefore, upon occurrence of such a state, a data transfer process termed dynamic relocation or garbage collection is executed in the system. This data transfer process eliminates, as illustrated on the right side of Fig. 3, the vacant area existing between the areas 1 and 2 and also another between the areas 2 and 3. In other words, the data storage areas are compressed to consequently widen the address space of the vacant area posterior to the area 3, hence realizing effective utilization of the main memory.

However, the address of the data stored in the area 2 or 3 is changed due to the data transfer process such as dynamic relocation or garbage collection, so that when the data stored in the area 2 or 3 is existent in the cache memory, there occurs a non-coincidence of the addresses. Accordingly it becomes necessary to render invalid the entire tag addresses stored in the directory memory DLM of the cache memory and then to execute the aforementioned data transfer between the cache memory and the main memory.

Taking notice of the fact that the valid data is stored in the data memory DTM at the execution of data transfer such as dynamic relocation or garbage collection in the main memory as mentioned, the present inventors have contrived effective utilization of such valid data. The contrivance is based on the discovery that the necessity is merely to change the addresses in the directory memory DLM automatically in accordance with such data transfer.

Concomitant with the operation of automatically rewriting the addresses in the directory memory DLM, the cache memory is additionally equipped with the following function. And due to addition of such function, there is newly provided, on the other input side of the tag comparator TCP, a signal path to receive the address signal from the main memory besides the known path to receive the address signal from the microprocessor MPU for use in the normal operation of the cache memory.

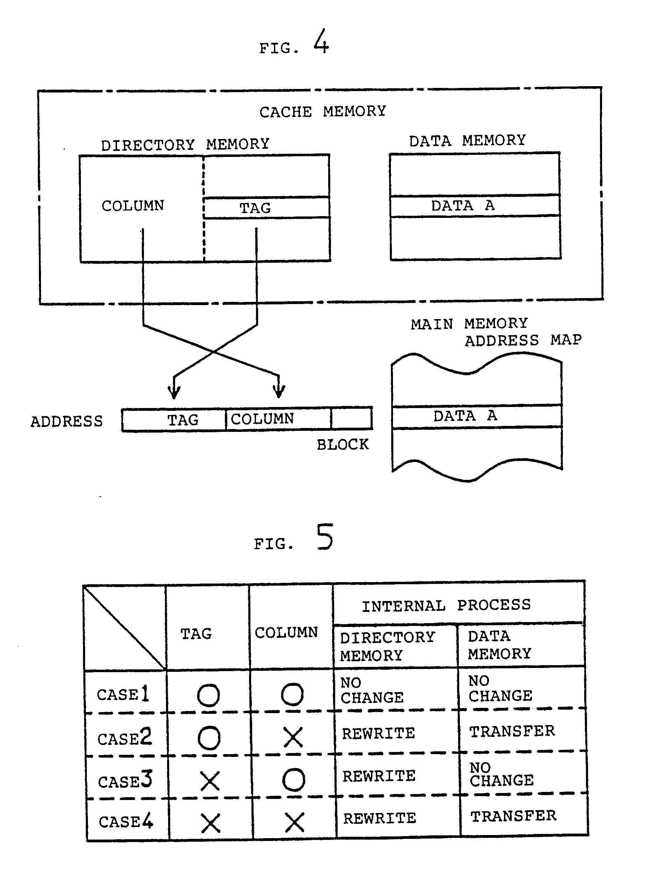

Fig. 4 shows an exemplary correspondence of the directory memory part and the data memory part in the cache memory to the address and the data in the address map of the main memory. One address storing the data A of the main memory therein can be specified from the tag address, the column address and the block address. In the directory memory, the address corresponds to the column address, and the tag address is stored as data in one address to be designated. The addresses in the directory memory and those in the data memory correspond to each other in a 1:1 relationship. More specifically, an address decoder is used in common for both the directory memory and the data memory as will be described later. Such address decoder performs selection of one address in response to the column address signal, and both the tag address and the data A are stored in such address. Although this embodiment is designed for a set associative type, the fundamental concept is the same with respect to a direct mapping type and a full associative type as well.

Fig. 5 shows operation modes with combinations of content changes or transfers in the directory memory part and the data memory part of the cache memory when dynamic relocation or garbage collection is executed in the main memory in a state where an address and data are stored in the cache memory as in the example of Fig. 4.

In case no data is existent in the cache memory, i.e. when a mis-hit is caused to the access from the microprocessor MPU, the above correspondence between the main memory and the cache memory is not necessary with regard to the dynamic relocation or garbage collection. Therefore, it is a matter of course that such is excluded from the combinations shown in Fig. 5.

In this diagram, a sign "o" denotes that a coincident tag or column of the post-change address designated in the main memory is existent in the cache memory; and a sign "x" denotes that none of such coincident tag or column is existent in the cache memory.

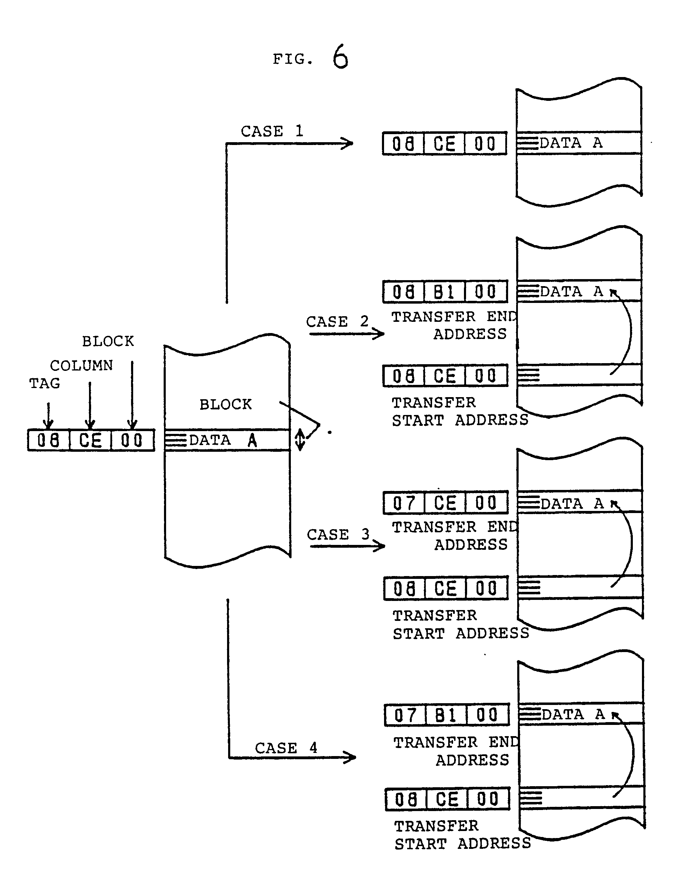

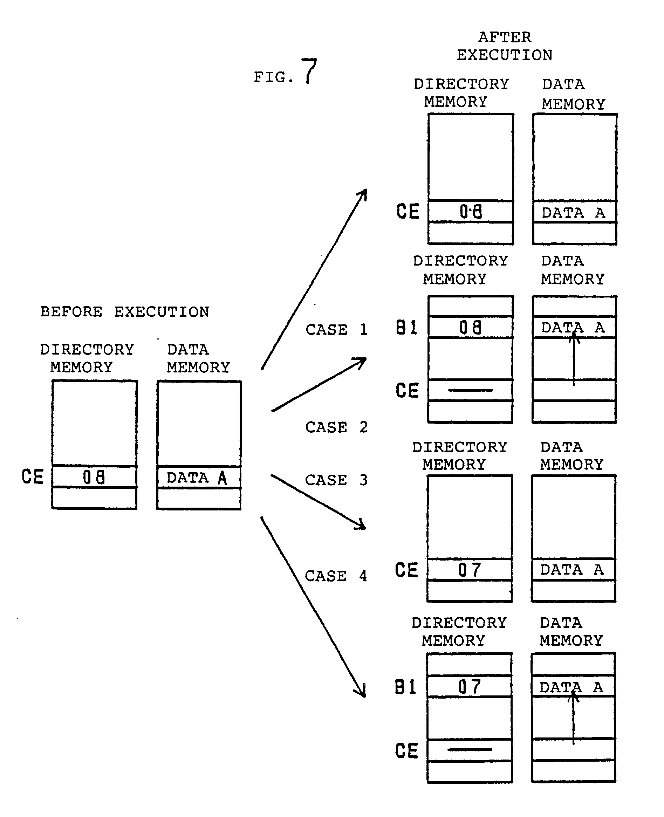

Fig 6 shows exemplar data transfers executed in the main memory due to the dynamic relocation or garbage collection in individual cases; and Fig. 7 shows exemplary data changes caused in the cache memory correspondingly to the above individual cases.

Hereinafter the combinations shown in Fig. 5 will be described with reference to Figs. 6 and 7.

In Case 1 where a tag and a column are both existent, it corresponds to, e.g. the region 1 of Fig. 3 free from substantial influence of any address change based on the dynamic relocation or garbage collection. In this case, the data A in the main memory includes a tag address 08, a column address CE and a block address 00 remaining unchanged as shown in Fig. 6, so that the contents of the directory memory and the data memory are not changed correspondingly thereto, as shown in Fig. 7.

Case 2 is an example where the columns have become mutually noncoincident. It represents a case where, as shown in Fig. 6, the column address out of the entire addresses for storage of the data A is changed from CE to B1. Then, as shown in Fig. 7, the address tag corresponding to the address CE in the directory memory is rendered invalid while a valid bit indicative of its validity or invalidity is reset, and simultaneously an address tag 08 is written in the portion corresponding to the new column B1. And in conformity therewith, a transfer of the data A is executed in the data memory.

Case 3 is an example where the tags have become mutually noncoincident. It represents a case where, as shown in Fig. 6, the address tag out of the entire addresses for storage of the data A is changed from 08 to 07. Then, as shown in Fig. 7, the address tag corresponding to CE in the directory memory is rewritten from 08 to 07, while the content of the data memory is left unchanged.

And Case 4 is an example where both the tags and the columns have become noncoincident. As shown in Fig. 6, the column address out of the entire addresses for storage of the data A is changed from CE to B1, and the address tag is changed from 08 to 07. Then the address tag corresponding to CE in the directory memory is rendered invalid while the valid bit indicative of its validity or invalidity is reset, and simultaneously a new address tag 07 is written in the portion corresponding to a new column B1. And in conformity therewith, a transfer of the data A is executed in the data memory.

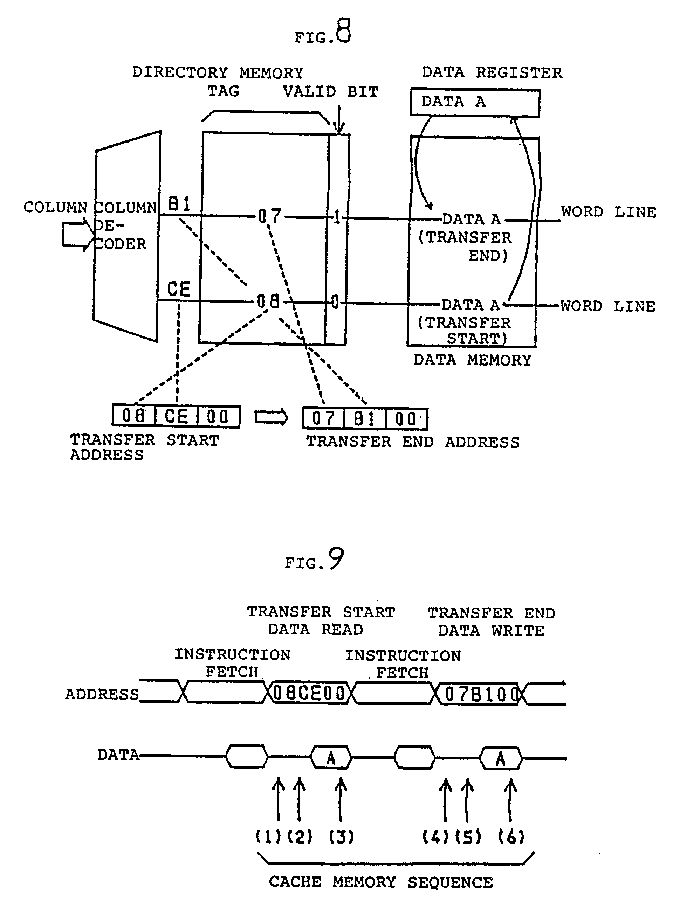

Fig. 8 is a conceptual diagram showing an

exemplary data transfer in the cache memory, and Fig. 9 is a timing chart relative to such data transfer.

The example shown in Figs. 8 and 9 represents Case 4 where the most complicated operation is required. That is, due to the dynamic relocation or garbage collection in the main memory, a data read instruction is fetched via the address bus of the main memory and then the data in the designated transfer start address is read out in response to such instruction. Meanwhile in the cache memory, the transfer start address signal (08CE00) on the main memory bus is fetched at timing (1). Subsequently the word line in the column address CE is selected at timing (2) out of the transfer start address signal thus fetched, whereby logic "0" is written in the valid bit of the directory memory at timing (3) to render the tag address 08 invalid. And simultaneously the data A is read out from the data memory and then is transferred to the data register.

Thereafter in the main memory a data write instruction is fetched and the data is written in the designated transfer end address in response to such instruction. Meanwhile in the cache memory, the transfer start address signal (07B100) on the main memory bus is fetched at timing (4). Subsequently the word line in the column address B1 is selected at timing (5) out of the transfer end address signal thus fetched, whereby a new tag address 07 is written in the directory memory at timing (6) and simultaneously logic "1" is written in the valid bit indicative of its validity. Meanwhile in the data memory, the data A is written in the data register.

For example, in Case 3 where the transfer end column addresses are mutually coincident, the word line of the column address CE is selected at timing (4), and a tag address 07 is written therein so that the valid bit is turned to logic "1" indicating its validity. Meanwhile in the data memory, the data A is written again in the same address, whereby the content of the directory memory is substantially rewritten while no change is made in the data memory.

In Case 2, the transfer end column address is changed to B1, so that the word line of the column address B1 is selected at timing (4), and then a tag address 08 is written therein to turn the valid bit to logic "1" indicative of its validity. In this stage, the data A from the data register is written in the address of the data memory corresponding to the column address B1, whereby the content of the directory memory is rewritten and the data transfer is executed in the data memory. Although a description has been given above with regard to Case 1 that no change is made apparently, the word line of the column address CE is selected at timing (4) since the transfer end column addresses are practically coincident, and the same tag address 08 is written therein to turn the valid bit to logic "1". Meanwhile in the data memory, the data A is written again in the same address. However, before and after a series of the above processes, there exists substantially no change in the directory memory and the data memory.

In the four exemplary cases mentioned hereinabove, the data processing steps executed in the cache memory are exactly the same, so that in the individual cases the automatic rewriting operation such as dynamic relocation or garbage collection required due to the data transfer in the main memory can be performed in the same sequence in the cache memory. It signifies that the data processing in each case can be executed by a signal control program.

According to the above-described constitution, the signal processing is performed uniformly to consequently achieve simplification of both the control program and the circuit configuration. That is, it becomes unnecessary to compare the transfer start address and the transfer end address with each other and to detect therefrom which of the column address and the address tag has been changed, and also to control the operation of writing in the directory memory and the data memory correspondingly to the address to be changed in accordance with the result of such detection.

When any address change has been made in the main memory by the process such as dynamic relocation or garbage collection, there occurs a mis-hit relative to the transfer start address if the relevant data is not existent in the cache memory. Therefore the cache memory disregards the address change of such data.

The functional and operational effects attained in the above embodiment are as follows:

(1) With respect to the process for changing the data storage address such as dynamic relocation or garbage collection in the main memory, the cache memory itself has a function of monitoring any address change in the main memory and automatically changing the internal address tag and/or data storage location in conformity with the data transfer end address, so that the data can be effectively utilized to consequently enhance the throughput of the system.

(2) The address tag and the data in the cache memory are once rendered invalid in conformity with the transfer start address in the main memory, and then the address tag and the data in the cache memory are written in conformity with the transfer end address in the main memory, whereby the address tag and/or the data storage location are automatically changed. Therefore a series of the data processing steps executed in the cache memory are entirely equalized regardless of the transfer start address and the transfer end address. Thus, the signal processing can be performed uniformly to eventually simplify both the processing control program and the circuit configuration.

Although the present invention has been described specifically with reference to an exemplary embodiment thereof, it is to be understood that the invention is not limited to the above embodiment alone, and a variety of modifications may be contrived within the scope not departing from the inventive concept. For example, the requirement in Case 3 mentioned may be satisfied in a modification so formed that the address tag is written on the one in the transfer end address by the aforementioned function only when the column address is hit out of the addresses rewritten in the cache memory. At that time, the data A in the data memory is left unchanged. Another modification may be such that when the column address alone is changed in the cache memory as in Case 2, an additional table is provided internally for writing the transfer end column therein, and no transfer is performed with respect to the tag address or the data either.

The cache memory may be so formed as to receive, in response to a predetermined control signal from the microprocessor MPU, an instruction to execute an address changing process for the data in the main memory such as the aforementioned dynamic relocation or garbage collection, and to load the transfer start address and the transfer end address while monitoring the address signal from the microprocessor. For ensuring a synchronous operation of the cache memory with the microprocessor MPU, the cache memory may be supplied with a clock signal CLK similarly to the microprocessor MPU as shown in Fig. 1. The practical constitution of the cache memory itself may be any of various types on condition that the same function as that defined in the aforementined embodiment is included.

It is to be noted that the present invention is widely applicable as a cache memory adapted for a buffer storage system.

[Effects of the Invention]

The advantageous effects achieved by the typical features of the invention disclosed in this application are briefly mentioned below. In conformity with a process such as dynamic relocation or garbage collection in the main memory for changing the data storage address, the cache memory itself has a function of monitoring the address change in the main memory and automatically changing the internal address tag and/or the data storage location in accordance with the data-transfer start address, hence attaining effective utilization of the data to consequently enhance the throughput of the system.

**Claims**

1. A cache memory having a function of monitoring any address change in a main memory and, in conformity with a data-transfer end address, automatically changing an internal address tag and/or a data storage location.

2. A cache memory according to claim 1, wherein the address change in the main memory is performed by executing a dynamic relocation or garbage collection.

3. A cache memory according to claim 1 or 2, wherein the address tag and the data in the cache memory are once rendered invalid in conformity with the transfer start address in the main memory, and then the address tag and the data in the cache memory are written in conformity with the transfer end address in the main memory, thereby automatically changing the address tag and/or the data storage location.

FIG. 1

EP 0 383 097 A2

FIG. 2

MEMORY BUS

MPU

AO
OT
CS

CACHE MEMORY

AD'
OT'
CS

MS CON-TROL-LER

MAIN MEMORY

SYSTEM BUS ADAPTOR

CRT

FRAME BUFFER

ROM

DMAC

FILE CON-TROL-LER

I/O

SYSTEM BUS

FIG. 3

## FIG. 4

## FIG. 5

| | TAG | COLUMN | INTERNAL PROCESS | |
|---|---|---|---|---|
| | | | DIRECTORY MEMORY | DATA MEMORY |
| CASE 1 | O | O | NO CHANGE | NO CHANGE |
| CASE 2 | O | X | REWRITE | TRANSFER |
| CASE 3 | X | O | REWRITE | NO CHANGE |
| CASE 4 | X | X | REWRITE | TRANSFER |

FIG. 6

CASE 1 → | 08 | CE | 00 | ≡ DATA A

CASE 2 → | 08 | B1 | 00 | ≡ DATA A
TRANSFER END
ADDRESS

| 08 | CE | 00 | ≡
TRANSFER
START ADDRESS

BLOCK
COLUMN
TAG

| 08 | CE | 00 | ≡ DATA A ↕ ⋅

BLOCK

DATA A

CASE 3 → | 07 | CE | 00 | ≡ DATA A
TRANSFER END
ADDRESS

| 08 | CE | 00 | ≡
TRANSFER
START ADDRESS

CASE 4 → | 07 | B1 | 00 | ≡ DATA A
TRANSFER END
ADDRESS

| 08 | CE | 00 | ≡
TRANSFER
START ADDRESS

FIG. 7

AFTER
EXECUTION

BEFORE EXECUTION

FIG.8

DIRECTORY MEMORY

TAG    VALID BIT

DATA REGISTER

DATA A

COLUMN COLUMN DE-CODER

81

07    1

DATA A (TRANSFER END)    WORD LINE

CE

08    0

DATA A (TRANSFER START)    WORD LINE

DATA MEMORY

| 08 | CE | 00 | ⇨ | 07 | 81 | 00 |

TRANSFER START ADDRESS

TRANSFER END ADDRESS

FIG.9

TRANSFER START DATA READ

TRANSFER END DATA WRITE

INSTRUCTION FETCH

INSTRUCTION FETCH

ADDRESS  ⟨08CE00⟩  ⟨07B100⟩

DATA  ⟨A⟩  ⟨A⟩

(1)(2)  (3)    (4)(5)  (6)

CACHE MEMORY SEQUENCE